# EUROPEAN PATENT APPLICATION

(11) **EP 4 383 942 A1**
(43) Date of publication of application: **12.06.2024**
(21) Application number: 22211981.0
(22) Date of filing: 07.12.2022
(51) Int. Cl.: H05B 6/06, H05B 6/12

(54) **INDUCTION HOB AND METHOD FOR DETERMINING ELECTRICAL CURRENT OF AN INDUCTION HOB**

(71) Applicant: ELECTROLUX APPLIANCES AKTIEBOLAG, 105 45 Stockholm (SE)
(72) Inventor: VIROLI, Alex, 47122 Forli (IT); NOSTRO, Massimo, 47100 Forli (IT); CHRISTIANSEN, Svend Erik, 47122 Forli (IT); ZANGOLI, Massimo, 47100 Forli (IT); ANGELI, Fabio, 47122 Forli (IT)
(74) Representative: Electrolux Group Patents

(57) **Abstract**

Induction hob (1) comprising one or more induction coils (3), mains supplying power lines (11) configured to supply a alternating main current (I1), a rectifying circuit (13), which is configured to rectify the alternating main current (I1) supplied by mains supplying lines (11) in order to output a rectified main current (I1), driving circuits (14) which are electrically connected with the rectifying circuit (13) by means of two rectified current lines, one of which is a ground voltage line (19); said driving circuits (14) comprises electronic switches (U1,U2) which are selectively controlled to regulate alternating secondary currents supplied to respective induction coils (3), an electronic control unit (10) which is configured to selectively control the electronic switches (U1,U2) of the driving circuits (14) in order to regulate said secondary currents flowing through said induction coils (3), electric resistance means (22) which have a prefixed electrical resistance and are electrically associated with the ground voltage line (19) upstream of the driving circuits (14), an electronic measurement unit (16) which is electrically connected with the ground voltage line (19) to measure a voltage drop (VD) across the electric resistance element (22) and provides an electric signal (VM) indicative of said measured voltage drop (VD) to the electronic control unit (10). The electronic control unit (10) is configured to determine the main current (11) based on the electric signal (VM).

## Description

### TECHNICAL FIELD

The present invention generally relates to the field of induction hobs. More specifically, the present invention concerns the determination of the mains current supplied by the mains lines to an induction hob.

### PRIOR ART

Induction hobs for preparing food are well known in prior art. Induction hobs typically comprise heating zones which are associated with induction coils. For heating a piece of cookware placed on a heating zone, the induction coils is electrically coupled with electronic driving units for driving an alternating current through the induction coil. The alternating current generates a time varying magnetic field. Due to the inductive coupling between the induction coils and the piece of cookware placed above the induction coil, the magnetic field generated by the induction coil causes eddy currents circulating in the piece of cookware. The presence of eddy currents generates heat within the piece of cookware due to the electrical resistance of the piece of cookware. Induction hobs further comprise a measurement circuit, which measures the total electric current supplied to the induction coils of the induction hob. The measurement circuit is configured to control the total electric current when the measured current does not meet a prefixed safety condition, i.e. total current is over a current threshold. A known measurement system comprises a transformer, which has the primary winding electrically coupled with a mains line supplying mains voltage to a first bridge rectifier of the induction hob, and a secondary winding, which is electrically connected with a current measuring circuit via a second bridge rectifier.

Disadvantageously, the transformer and second bridge rectifier circuit in the measuring system are expensive and subjected to failures, which requires maintenances work and relative costs.

The object of the present invention is therefore to provide an induction hob provided with a measurement circuit, which is simple and cheaper than the measurement system above disclosed.

In accordance with this object according to the present invention, and induction hob provided with a measurement circuit and a method for determining a current supplied to an induction hob are provided as defined in the related independent claims, and preferably, but not necessarily, in any one of the claims dependent thereon.

The claims describe preferred embodiments of the present invention forming an integral part of the present specification.

If not explicitly indicated otherwise, embodiments of the invention can be freely combined with each other.

According to an aspect of the invention, the invention relates to an induction hob comprising and induction hob comprising: one or more induction coils, mains supplying power lines configured to supply a alternating main current, a rectifying circuit, which is configured to rectify the alternating main current supplied by said mains supplying lines in order to output a rectified main current, one or more driving circuits which are electrically connected with said rectifying circuit by means of two rectified current lines, one of which is a ground voltage line; said driving circuits comprises one or more electronic switches, which are selectively controlled to regulate alternating secondary currents supplied to respective induction coils, an electronic control unit which is configured to selectively control said one or more electronic switches of said driving circuits in order to regulate said secondary currents flowing through said induction coils, an electric resistance element, which has a prefixed electrical resistance and is electrically associated with said ground voltage line upstream of said driving circuits, an electronic measurement unit which is electrically connected with said ground voltage line to measure a voltage drop across said electric resistance element and provides an electric value/signal indicative of said measured voltage drop to said electronic control unit; said electronic control unit is configured to determine said main current based on said electric value/signal.

Preferably, the induction hob comprises an induction printed circuit board provided with at least said rectifying circuit, said driving circuits and one or more circuit tracks, one of said circuit tracks is a ground track which is said ground voltage line; said electric resistance element is a part of said ground track having said prefixed electrical resistance.

Preferably, the electronic measurement unit is electrically connected with ends of said part of a said ground track of said printed circuit board.

Preferably, said ground track of said ground voltage line has a first terminal connected with a terminal of said rectifying circuit having a negative voltage and a second terminal connected with a terminal of said driving circuits having a ground voltage. Preferably, said electronic measurement unit has two terminals electrically connected with two ends of said part of the ground track and is configured to measure the voltage drop across said part.

Preferably, said ground track of said induction printed circuit board does not comprise any shunt-resistor.

Preferably said ground voltage line is a low frequency line.

Preferably said electric resistance element comprises a shunt resistor, which is configured in order to have said prefixed resistance and is arranged along said ground voltage line in series with the latter; said electronic measurement unit has two terminals electrically connected with two ends of said shunt resistor.

Preferably, said electronic measurement unit comprises an operational amplifier stage having two ends connected with two ends of said electric resistance element.

Preferably, said operational amplifier stage is configured in order to provide said value/signal by performing a voltage offset addition on said measured voltage drop. The present invention further relates to a method for determining a mains current which is supplied to an induction hob by mains supplying lines, wherein said mains supplying lines are configured to supply an alternating main current to the induction hob, the induction hob comprising: a rectifying circuit, which is configured to rectify the alternating main current supplied by said mains supplying lines in order to output a rectified main current, driving circuits which are electrically connected with said rectifying circuit by means of two power supplying lines, one of which is a ground voltage line; said driving circuits comprise one or more electronic switches which are selectively controlled to regulate alternating secondary currents supplied to respective induction coils, an electronic control unit which is configured to selectively control said one or more electronic switches of driving circuits in order to regulate said secondary currents flowing through said induction coils, said method comprising: arranging an electric resistance element which has a prefixed electrical resistance on said ground voltage line upstream said driving circuits, measuring a voltage drop across said electric resistance element by an electronic measurement unit which is electrically connected with said ground voltage line to provide a signal/value indicative of said measured voltage drop to said electronic control unit, determining said main current by said electronic control unit based on said signal/value.

Preferably, the induction hob comprises an induction printed circuit board provided with at least said rectifying circuit, said driving circuits and circuit tracks, wherein said ground voltage line consisting of a ground track; the method comprises the step of electrically connecting said electronic measurement unit to a part of said ground track having said prefixed electrical resistance; said electric resistance element consisting of said part of said ground track of said printed circuit board.

Preferably, the method further comprises the step of connecting a first end of said ground track with a terminal of said rectifying circuit having a negative voltage and connecting a second end of said ground track of said ground voltage line with a terminal of said driving circuits having a ground voltage.

Preferably, said electric resistance element consists of a shunt resistor along said ground voltage line in series with the latter.

Preferably, the method further comprises the step of performing a voltage offset addition on said measured voltage drop by a operational amplifier stage.

### BRIEF DESCRIPTION OF THE DRAWINGS

The various aspects of the invention, including its particular features and advantages, will be readily understood from the following detailed description and the accompanying drawings, in which:
Fig. 1 schematically illustrates an induction hob provided according to the present invention,
Fig. 2 illustrates a block diagram of an electric circuit of and induction-heating hob according to some embodiments of the present invention,
Fig. 3 illustrates the circuit diagram of the rectifying circuit, the driving circuits and the driver unit of the induction hob according to a first embodiment of the present invention,
Fig. 4 illustrates an example the measurement circuit of the induction hob the present invention,
Fig. 5 illustrates an example of the circuit diagram of the rectifying circuit, the driving circuits and the driver unit of the induction hob according to a second embodiment of the present invention.

### PREFERRED EMBODIMENTS OF THE INVENTION

The present invention will now be described more fully with reference to the accompanying drawings, in which example embodiments are shown. However, this invention should not be construed as limited to the embodiments set forth herein. Throughout the following description similar reference numerals have been used to denote similar elements, parts, items or features, when applicable.

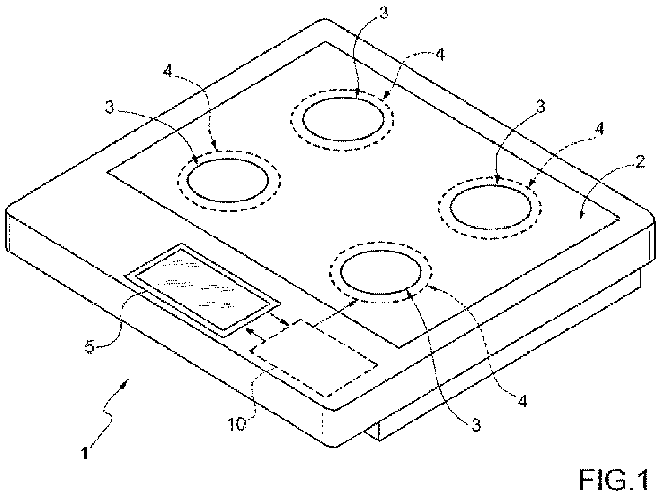

With reference to Figure 1, number 1 indicates, as a whole, an induction hob made according to the present invention.

The induction hob 1 may comprise multiple heating zones 4 (shown by broken lines) which are arranged on a hob plate 2.

With reference to the exemplary embodiment shown in Figure 1, each heating zone 4 is associated with at least one induction coil 3. Preferably, the induction coil 3 is arranged under the hob plate 2.

In the example shown in Figure 1, the induction hob 1 further comprises a user interface 5. The user interface 5 may be configured to allow the user to input/set commands for operating the induction hob 1.

The user interface 5 may be further configured in order to provide the user information concerning the operating of the induction hob 1.

The information may conveniently comprise graphical information and the user interface may comprise, for example a touch screen display.

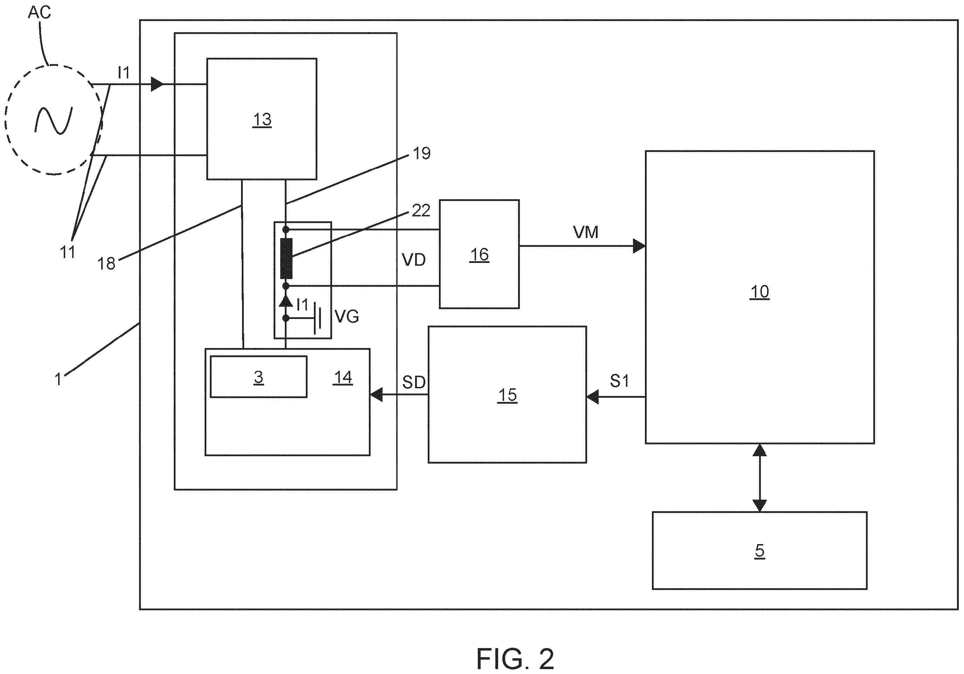

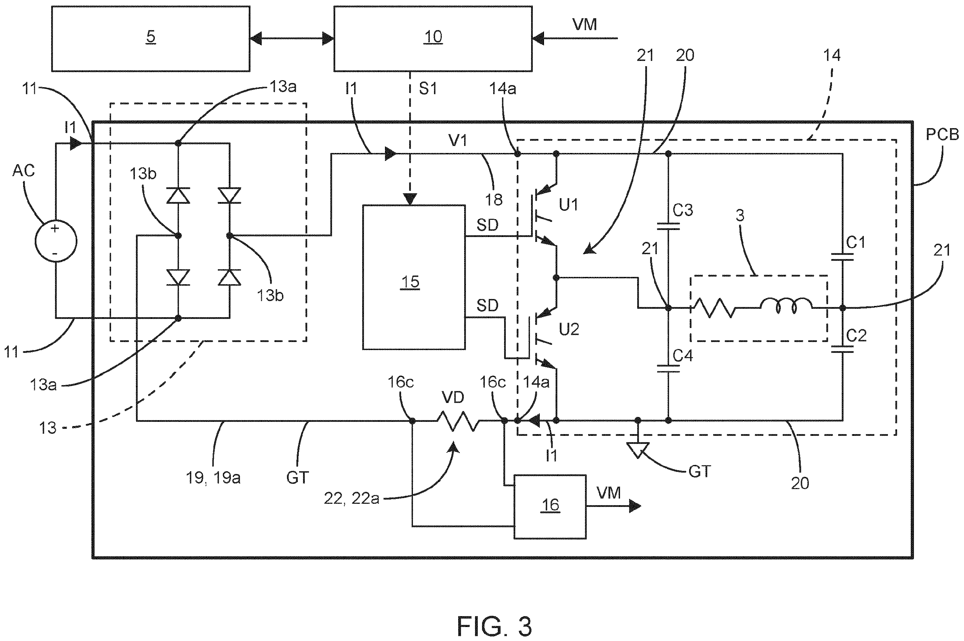

Figure 2 is a block diagram showing a configuration of the induction hob 1 according to an embodiment of the present invention. Referring to Figures 2, the induction hob 1 comprises two mains supplying power lines 11, an electronic control unit 10, a rectifying unit 13, one or more driving circuits 14 (only one illustrated in Figure 2 and 3), and one or more driver units 15 (only one illustrated in Figures 2 and 3), and a measurement unit 16.

The mains supplying power lines 11 are electrically connected with an alternating current network AC and are configure to supply a main alternating current I1 to the induction hob 1.

The rectifying unit 13 is connected with the mains supplying power lines 11 for receiving the alternating main current I1. The rectifying unit 13 is configured to rectify the alternating main current I1 supplied by the mains supplying power lines 11 in order to provide a direct supplying current I1.

As illustrated in the example of Figure 3, the rectifying unit 13 may comprise a plurality of diodes, which are connected one to the other in order to form a bridge rectifier. As illustrated in the example of Figure 3, the rectifying unit 13 comprises two nodes 13a, which are electrically connected with the supplying mains supplying power lines 11 respectively, and two nodes 13b which are electrically connected with two terminals 14a of the driving circuit 14 by supplying lines.

The rectified/direct supplying current I1 flows through the supplying lines. In the example shown in Figure 3, a supplying line is a voltage line 18 having a prefixed voltage V1 (different from zero medium voltage, i.e. 220V) which depends on the voltage of the alternating current network AC, whereas the other supplying line is a ground line 19 having a ground voltage (0V). In the example illustrated in Figure 3 the ground line 19 is electrically connected to a ground terminal GT. It is understood that the ground line 19 is a low frequency line.

The driving circuit 14 is electrically connected with the induction coil 3 and is configured to supply the electric power, i.e. the current and voltage to the induction coil 3.

In the example illustrated in Figure 3, the driving circuit 14 comprises two power lines 20 electrically connected with the supplying lines 18, 19, and a switching stage 21 electrically connected with the power lines 20.

The switching stage 21 may comprise one or more switching devices U1 and U2.

In the example illustrated in Figure 3, the switching stage 21 comprises a plurality of switching devices U1 and U2, and two capacitive branches comprising respective couple of capacitors C1, C2 and C3, C4.

In the example illustrated in Figure 3, the switching devices U1 and U2 are connected in series between the power lines 20. The switching devices U1 and U2 may comprise transistors. For example, transistors may comprise insulated gate bipolar transistors (IGBT) or other similar transistors. It is understood that the present invention is not limited to bipolar transistors but may envisage other transistors or similar electronic switches.

In the example illustrated in Figure 3, the ends of the capacitive branches are electrically connected with the power lines 20. The capacitors C1, C2 and C3, C4 of the capacitive branches are connected in series by common nodes 21 which are connected with the ends of induction coil 3.

In the example illustrated in Figure 3 the driver unit 15 is configured in order to receive a control signal S 1 from the electronic control unit 10 and generates driving signals SD which control the switching devices U1 and U2 based on the control signal S1. The driving signals SD may comprise pulsed signals, which are configured in order to cause the switching devices U1 and U2 to alternately operate based on a high switching frequency to provide an alternating current flowing through the induction coil 3 thereby generating a high frequency magnetic flux.

It is understood that according to a possible embodiment (not shown) if the switching stage 21 comprises a switching device, the driving signals SD may comprise a pulsed signal, which is configured in order to cause the switching device to operate based on a high switching frequency to provide an alternating current flowing through the induction coil 3 thereby generating the high frequency magnetic flux.

With reference to Figures 1, 2 and 3, the electronic control unit 10 is electrically connected with the user interface 5 to receive commands imparted by the user for operating the induction hob 1.

The electronic control unit 10 may provide the control signal S 1 based on the commands received from the user interface 5.

With reference to Figures 2 and 3, the induction hob 1 may comprise an electric resistance element 22.

The electric resistance element 22 is electrically connected along the ground line 19 (in series). Preferably, the electric resistance element 22 is configured in order to have a prefixed electrical resistance.

According to a preferred embodiment illustrated in Figure 3, the induction hob 1 comprises an induction printed circuit board PCB, which is provided with at least the rectifying circuit 13, the driving circuits 14 and circuit tracks (printed circuits/lines/branches), which electrically connects the electronic components of the printed circuit board PCB. At least one of circuit tracks 19a of the printed circuit board is a ground track. The ground track 19a is the ground line 19.

The electric resistance element 22 is conveniently part 22a (i.e. a piece or portion) of the ground track 19a and have the prefixed electrical resistance. In other words, the part 22a of the ground track 19a forms the electric resistance element 22.

The electronic measurement unit 16 is electrically connected with the ends of the part 22a of the ground track 19a of the ground line 19 and is configured to measure a voltage drop VD across the part 22a of the ground track 19a in order to provide a voltage signal VM indicative of the measured voltage drop VD to the electronic control unit 10.

The electronic control unit 10 is configured to receive the voltage signal VM, determines the measured voltage drop VD based on the voltage signal VM and determines the total current I1 based on the measured voltage drop VD and the prefixed resistance.

It is understood that total current I1 determined by the electronic control unit 10 is indicative of the total current consumption of the induction hob 1.

It is further understood that the total current determined by the electronic control unit 10 may be indicative of the direct supplying current I1 and/or the mains alternating current I1 provided by the network AC to the induction hob 1.

According to an exemplary embodiment, the part 22a of the ground track 19a of the printed circuit board PCB used by the electronic measurement unit 16 to determine the voltage drop VD, may be defined/structured in order to have the prefixed electrical resistance. The prefixed resistance may be of about 0.0123 Ohm.

It is further understood that according to the embodiment illustrated in Figure 3 in which the electric resistance element 22 is the he part 22a of the ground track 19a of the printed circuit board PCB, the ground line 19 does not comprise any shunt resistor. The Applicant has found that using the part 22a of the ground track 19a as an electric resistor element to determine/measure the current consumption of the induction hob 1, is convenient because it allows to reduce the costs.

Indeed it is possible to determine the total current consumption by using components, i.e. tracks of the printed circuit board of the induction hob 1 without adding additional electronic components along the lines, like for example additional resistor.

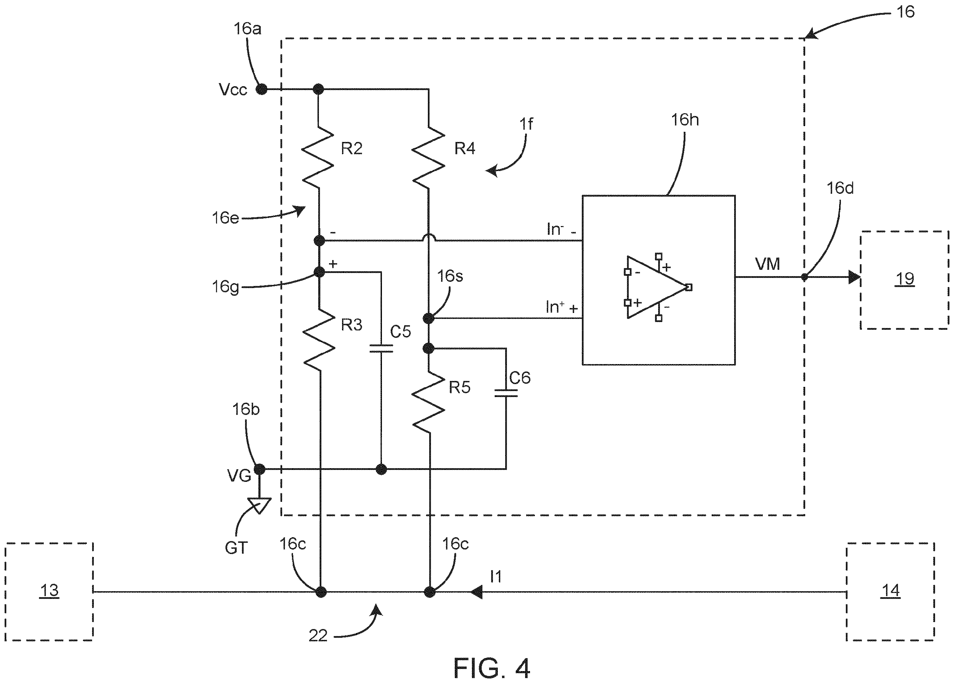

With reference to an exemplary embodiment illustrated in Figure 4, the measurement unit 16 comprises a terminal 16a having a supplying voltage Vcc (for example 5V), a terminal 16b having a ground terminal GT having a ground voltage VG (0 V), two terminal 16c electrically connected with a first end and second end of the electric resistance element 22, and a terminal 16d providing the determined voltage signal VM to the electronic control unit 10.

With reference to an exemplary embodiment illustrated in Figure 4, the electronic measurement unit 16 further comprise an operational amplifier stage 16h, and two resistive branches 16e and 16f. The resistive branch 16e comprises two resistors R2 and R3, which are connected between the terminal 16a and a first end of the electric resistance element 22. Resistors R2 and R3 are connected in series to each other by a common node 16g. The common node 16g is electrically connected with the inverting input In⁻ of the operational amplifier stage 16h.

The resistive branch 16f comprises two resistors R4 and R5, which are connected in series between the terminal 16a and the second end 16c of the electric resistance element 22. Resistors R4 and R5 are connected one to the other by a common node 16s. The common node 16s is electrically connected with the non-inverting input In⁺ of the operational amplifier stage 16h.

Resistors R2 and R4 are configured in order to operate as pull-up resistors. Pull-up resistors R21 and R4 are configured in order to add an offset to the voltage, so it is always higher than 0V.

That has the technical effect of providing a positive voltage VM in input to the electronic control unit 10 when the latter comprises a microcontroller o microprocessor. In other words, that has the technical effect of using integrated components of an existing micro controller without adding extra circuits.

This solve the technical problem of micro controllers to operate with negative voltages on the inputs. Indeed negative voltage causes the micro controller to have an integrated differential (AD) input with a gain amplifier. However, the integrated differential (AD) input increases costs.

It is further understood that the voltage drop VD on the ground track 19a is low and can be subjected by noise. According to the first embodiment of the present invention, the electronic measurement unit 16 is conveniently configured to implement a differential measurement for noise suppression and a voltage shift to enable measurement of the negative voltage. The measurement is implemented conveniently by using the operational amplifier stage 16h and by taking advantage of the internal capabilities of microcontroller of the electronic control unit 10 in order to perform differential measurements and gain amplification.

With reference to the exemplary embodiment illustrated in Figure 4, the electronic measurement unit 16 further comprises two capacitors C5 and C6. The capacitor C5 is electrically connected between the node 16g and the ground terminal 16b. The capacitor C6 is electrically connected between the node 16s and the ground terminal 16b.

According to an exemplary embodiment, the electronic measurement unit 16 is configured in order to: measure a voltage difference between the voltages present on the inverting In⁻ input and non-inverting In⁺ input of the operational amplifier stage 16h respectively, and providing a differential value/signal VM preferably indicative of the voltage difference, in input of (the microcontroller of) the electronic control unit 10.

According to an exemplary embodiment, (the microcontroller of) the electronic control unit 10 may be configured in order to integrate the differential value/signal VM, i.e. by an integrated AD converter module (not illustrated), and amplifying the differential value based on (for example when available) a programmed gain factor of the operational amplifier stage 16h.

It is understood that the differential value/signal VM measured between the non-inverting In⁻ input and the inverting input In⁺ of the operational amplifier stage 16e in a condition of "zero current" i.e. when the current flowing the ground line 19 is zero, may be different than zero due to tolerances of the electronic components of the electronic measurement unit 16.

In order to compensate said tolerances, an auto-calibration algorithm (software) may be performed by the electronic control unit 10. It is understood that the calibration may be conveniently performed either at factory or using the auto calibration algorithm in runtime. When the auto-calibration is performed and determine that total current is zero, the electronic measurement unit 16 may determine an offset (voltage) based on the difference value measured in input. Preferably the difference value may be stored in a memory (not illustrated) of the electronic control unit 10. The electronic control unit 10 may be configured to apply the difference value as an offset when the induction hob 1 operates, so that the total current 11 is calculated based on the measured value and the stored offset determined during the calibration.

It is understood that alternatively, the algorithms parameters may be calibrated into memory at production in the factory to compensate for tolerances.

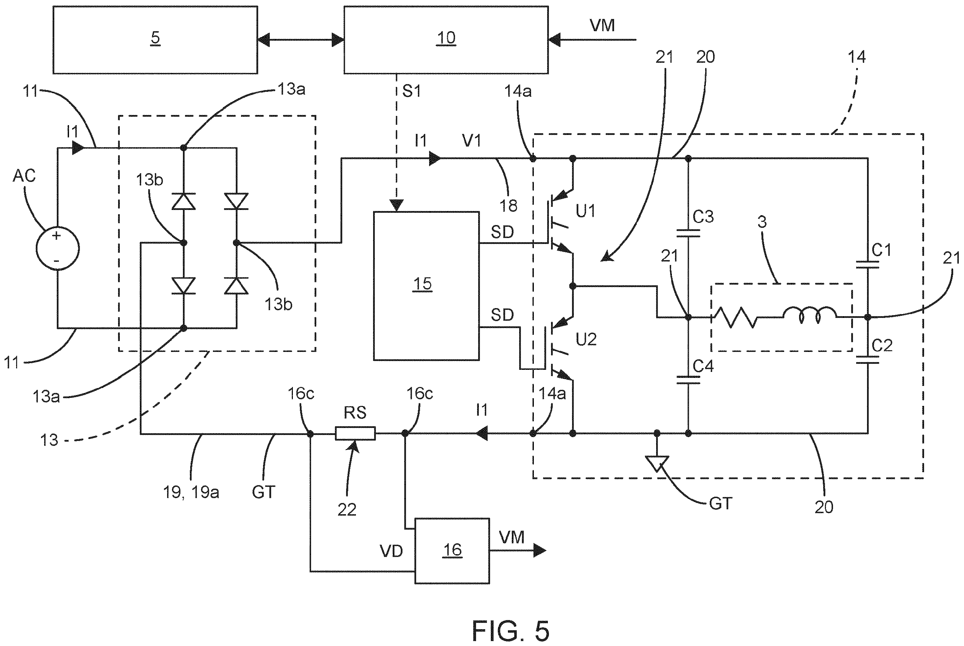

Figure 5 illustrates an embodiment of the induction hob 1 which differs from the embodiment illustrated in Figure 3 in that the electric resistance element 22 comprises a shunt resistor RS which is connected in series along the ground line 19 upstream the driving circuit 14. Terminals of the electronic measurement unit 16 are electrically connected with the ends of the shunt resistor RS. Preferably, the shunt resistor RS has a resistance of about 0,1 Ohm.

The present invention have the advantage of provide a cost saving compared with prior art circuits.

Clearly, changes and variations may be made to the cooking appliance, the method and the electronic system, however, departing from the scope of the present invention.

## Claims

1. Induction hob (1) comprising:
- one or more induction coils (3),
- mains supplying power lines (11) configured to supply a alternating main current (I1),
- a rectifying circuit (13), which is configured to rectify the alternating main current (I1) supplied by said mains supplying lines (11) in order to output a rectified main current (I1),
- one or more driving circuits (14) which are electrically connected with said rectifying circuit (13) by means of two rectified current lines, one of which is a ground voltage line (19); said driving circuits (14) comprises one or more electronic switches (U1,U2) which are selectively controlled to regulate alternating secondary currents supplied to respective induction coils (3),
- an electronic control unit (10) which is configured to selectively control said one or more electronic switches (U1,U2) of said driving circuits (14) in order to regulate said secondary currents flowing through said induction coils (3),
- a electric resistance element (22) which has a prefixed electrical resistance and is electrically associated with said ground voltage line (19) upstream of said driving circuits (14),
- an electronic measurement unit (16) which is electrically connected with said ground voltage line (19) to measure a voltage drop (VD) across said electric resistance element (22) and provides an electric value/signal (VM) indicative of said measured voltage drop (VD) to said electronic control unit (10);
said electronic control unit (10) is configured to determine said main current (I1) based on said electric value/signal (VM).

2. Induction hob according to claim 1, comprising an induction printed circuit board (PCB) provided with at least said rectifying circuit (13), said driving circuits (14) and one or more circuit tracks, one of said circuit tracks is a ground track (19a) which is said ground voltage line (19); said electric resistance element is a part (22a) of said ground track (19a) having said prefixed electrical resistance.

3. Induction hob according to claim 2, wherein said electronic measurement unit (16) is electrically connected with ends of said part (19a) of a said ground track (22a) of said printed circuit board (PCB).

4. Induction hob according to claim 3, wherein said ground track (19a) of said ground voltage line (19) has a first terminal connected with a terminal of said rectifying circuit (13) having a negative voltage and a second terminal connected with a terminal of said driving circuits (14) having a ground voltage (VG).

5. Induction hob according to claims 2 or 3, wherein said electronic measurement unit (16) has two terminals electrically connected with two ends (16c) of said part (22a) of the ground track (19a) and is configured to measure the voltage drop (VD) across said part (19a).

6. Induction hob according to any of the foregoing claims from 2 to 5, wherein said ground track (19a) of said induction printed circuit board (PCB) does not comprise any shunt-resistor.

7. Induction hob according to any of the foregoing claims, wherein said ground voltage line (19) is a low frequency line.

8. Induction hob according to claim 1, wherein said electric resistance element (22) comprises a shunt resistor (RS), which is configured in order to have said prefixed resistance and is arranged along said ground voltage line (19) in series with the latter; said electronic measurement unit (16) has two terminals electrically connected with two ends (16c) of said shunt resistor (RS).

9. Induction hob according to any of the foregoing claims, wherein said electronic measurement unit (16) comprises an operational amplifier stage (16h) having two ends connected with two ends of said electric resistance element (22).

10. Induction hob according to claim 9, wherein said operational amplifier stage (16h) is configured in order to provide said value/signal (VM) by performing a voltage offset addition on said measured voltage drop (VD).

11. Method for determining a mains current (I1) which is supplied to an induction hob (1) by mains supplying lines (11), wherein said mains supplying lines (11) are configured to supply an alternating main current (I1) to the induction hob (1), the induction hob (1) comprising:
- a rectifying circuit (13), which is configured to rectify the alternating main current (I1) supplied by said mains supplying lines (11) in order to output a rectified main current (I1),
- driving circuits (14) which are electrically connected with said rectifying circuit (13) by means of two power supplying lines, one of which is a ground voltage line (19); said driving circuits (14) comprise one or more electronic switches (U1, U2) which are selectively controlled to regulate alternating secondary currents supplied to respective induction coils (3),
- an electronic control unit (10) which is configured to selectively control said one or more electronic switches (U1, U2) of driving circuits (14) in order to regulate said secondary currents flowing through said induction coils (3),
said method comprising:
- arranging an electric resistance element (22) which has a prefixed electrical resistance on said ground voltage line (19) upstream said driving circuits (14),
- measuring a voltage drop (VD) across said electric resistance element (22) by an electronic measurement unit (16) which is electrically connected with said ground voltage line (19) to provide a signal/value (VM) indicative of said measured voltage drop (VM) to said electronic control unit (10),
- determining said main current (I1) by said electronic control unit (10) based on said signal/value (VM).

12. Method according to claim 11, wherein said induction hob (1) comprises an induction printed circuit board (PCB) provided with at least said rectifying circuit (13), said driving circuits (14) and circuit tracks, wherein said ground voltage line (19) consisting of a ground track;
said method comprising the step of electrically connecting said electronic measurement unit (16) to a part (19a) of said ground track having said prefixed electrical resistance; said electric resistance element (22) consisting of said part (19a) of said ground track of said printed circuit board (PCB).

13. Method according to claim 12, comprising the step of connecting a first end of said ground track with a terminal of said rectifying circuit (13) having a negative voltage and connecting a second end of said ground track of said ground voltage line (19) with a terminal of said driving circuits (14) having a ground voltage (VG).

14. Method according to claim 11, wherein said electric resistance element (22) consists of a shunt resistor (RS) along said ground voltage line (19) in series with the latter.

15. Method according to any of the foregoing claims from 11 to 14, comprising the step of performing a voltage offset addition on said measured voltage drop by a operational amplifier stage (16h).
